# EUROPEAN PATENT APPLICATION

(11) **EP 4 312 276 A1**
(43) Date of publication of application: **31.01.2024**
(21) Application number: 22196061.0
(22) Date of filing: 16.09.2022
(51) Int. Cl.: H01L 29/778, H01L 29/417, H01L 29/06, H01L 21/338, H01L 29/45, H01L 29/20

(54) **GALLIUM NITRIDE DEVICE AND METHOD FOR MANUFACTURING HIGH ELECTRON MOBILITY TRANSISTOR**

(30) Priority: 29.07.2022 TW 111128546
(71) Applicant: United Microelectronics Corp., Hsinchu (TW)
(72) Inventor: YEH, Chih Tung, Taoyuan City 320008 (TW); HOU, Chun-Liang, Jhubei City, Hsinchu County 302 (TW)
(74) Representative: Becker, Eberhard

(57) **Abstract**

A gallium nitride device and a method for manufacturing a high electron mobility transistor are provided. The gallium nitride device includes a substrate (100), a channel layer (102) disposed on the substrate, a barrier layer (104) disposed on the channel layer, a cap layer (106) disposed on the barrier layer, a gate (108) disposed on the cap layer, a source (110a), a drain (110b), and ohmic sidewall dams (112). The source and the drain are formed in the cap layer and the barrier layer. Each of the source and the drain has a trench portion (T01, T02), and a contact (C01, C02) below the trench portion and protruding into the channel layer. The ohmic sidewall dams are disposed on a sidewall of the trench portion of each of the source and the drain.

## Description

### BACKGROUND

### Technical Field

The disclosure relates to a semiconductor device, and particularly to a gallium nitride (GaN) device and a method for manufacturing a high electron mobility transistor (HEMT).

### Description of Related Art

A high electron mobility transistor (HEMT) may be applied in a high frequency device and a high voltage device, and has characteristics such as high breakdown voltage, high saturation electron mobility and high temperature operation capability.

In a typical HEMT, a two-dimensional electron gas (2DEG) is generated at a semiconductor heterojunction to have highly mobile and highly concentrated charge carriers, and the charge carriers are free to move in two dimensions of the 2DEG.

In a current gallium nitride high electron mobility transistor (GaN HEMT), a barrier layer and a cap layer as a protective layer are formed above the 2DEG. Since the cap layer also includes a material (such as gallium nitride or aluminum nitride) having semiconductor characteristics, when a metal gate is formed thereon, leakage from the gate to a source or a drain tends to occur, thus affecting electric characteristics of the device.

### SUMMARY

The disclosure provides a gallium nitride (GaN) device in which leakage from a gate to a source or a drain as well as leakage from a source to a drain can be prevented, thereby improving electrical properties of the device.

The disclosure further provides a GaN device in which contact resistance (Rc) can be reduced and an ohmic sidewall dam that blocks a leakage path is provided.

The disclosure further provides a method for manufacturing a high electron mobility transistor (HEMT), in which a hump phenomenon in Id-Vg of a device can be suppressed.

A GaN device according to the disclosure includes a substrate, a channel layer disposed on the substrate, a barrier layer disposed on the channel layer, a cap layer disposed on the barrier layer, a gate disposed on the cap layer, a source, a drain, and multiple ohmic sidewall dams. The source and the drain are formed in the cap layer and the barrier layer. Each of the source and the drain has a trench portion, and a contact below the trench portion and protruding into the channel layer. The ohmic sidewall dams are disposed on a sidewall of the trench portion of each of the source and the drain.

In an embodiment of the disclosure, a two-dimensional electron gas (2DEG) may be generated in the channel layer close to the barrier layer, and the contact of each of the source and the drain may be in direct contact with the 2DEG.

Another GaN device according to the disclosure includes a substrate, a channel layer disposed on the substrate, a barrier layer disposed on the channel layer, a cap layer disposed on the barrier layer, a gate disposed on the cap layer, a source, a drain, multiple ohmic sidewall dams, multiple titanium nitride (TiN) protrusions, and a gold (Au)-containing layer. The source and the drain are formed in the cap layer and the barrier layer, and a material of the source and the drain includes gold (Au) and titanium (Ti). The ohmic sidewall dams are disposed on a sidewall of the source and the drain. The TiN protrusions are located below the source and the drain and protrudes into the channel layer. The Au-containing layer is located below the TiN protrusions.

In another embodiment of the disclosure, a 2DEG may be generated in the channel layer close to the barrier layer, and the TiN protrusions may be in direct contact with the 2DEG.

In any of the above embodiments of the disclosure, the GaN device may further include a passivation layer covering the gate and the cap layer.

In any of the above embodiments of the disclosure, the ohmic sidewall dams may further be disposed between the gate and the passivation layer.

In any of the above embodiments of the disclosure, a material of the ohmic sidewall dams may include silicon nitride, silicon oxide, aluminum oxide, aluminum nitride, or a combination thereof.

In any of the above embodiments of the disclosure, each of the source and the drain may have a multi-layered structure composed of multiple bowl-shaped stacks.

In any of the above embodiments of the disclosure, the material of the source and the drain may further include molybdenum (Mo), aluminum (Al), titanium (Ti), or a combination thereof.

A method for manufacturing a high electron mobility transistor (HEMT) according to the disclosure includes the following. A channel layer is formed on a substrate. A barrier layer is formed on the channel layer. A cap layer is formed on the barrier layer. A gate is formed on the cap layer. Multiple trenches are formed penetrating through the cap layer and the barrier layer. Multiple ohmic sidewall dams are formed on a sidewall of the trenches. Multiple openings are formed below the trenches into the channel layer. A source and a drain are formed in the trenches and the openings, and the source and the drain are separated from the cap layer by the ohmic sidewall dams.

In still another embodiment of the disclosure, a method for forming the source and the drain may include a dual damascene process.

In still another embodiment of the disclosure, forming the source and the drain may include the following. A metal material is deposited in the trenches and the openings. The metal material is patterned.

In still another embodiment of the disclosure, forming the source and the drain may include the following. A metal material is deposited to fill the trenches and the openings. The metal material except that in the trenches and the openings is lifted off.

In still another embodiment of the disclosure, forming the ohmic sidewall dams may include the following. A dielectric material is conformally deposited on the sidewall and a bottom of each of the trenches. A portion of the dielectric material at the bottom of each of the trenches is removed.

In still another embodiment of the disclosure, a method for depositing the dielectric material may include an atomic layer deposition (ALD) method.

To make the aforementioned more comprehensible, several embodiments accompanied with drawings are described in detail as follows.

### BRIEF DESCRIPTION OF THE DRAWINGS

FIG. 1 is a schematic cross-sectional view of a GaN device according to a first embodiment of the disclosure.
FIG. 2 is a schematic cross-sectional view of a GaN device according to a second embodiment of the disclosure.
FIG. 3A to FIG. 3E are schematic cross-sectional views of a method for manufacturing a HEMT according to the second embodiment of the disclosure.

### DESCRIPTION OF EMBODIMENTS

The disclosure relates to a GaN device technology applied in a high frequency device and a high voltage device. In the disclosure, by disposing an ohmic sidewall dam in a device, leakage from a gate to a source or a drain can be blocked and the hump phenomenon in Id-Vg of the device can be suppressed. In the disclosure, the source and the drain have, in or below themselves, a structure that can be in contact with a 2DEG, which is advantageous in reducing contact resistance (Rc).

The following will describe some embodiments as examples of the disclosure. However, the disclosure is not limited to the embodiments. The embodiments may be combined with each other.

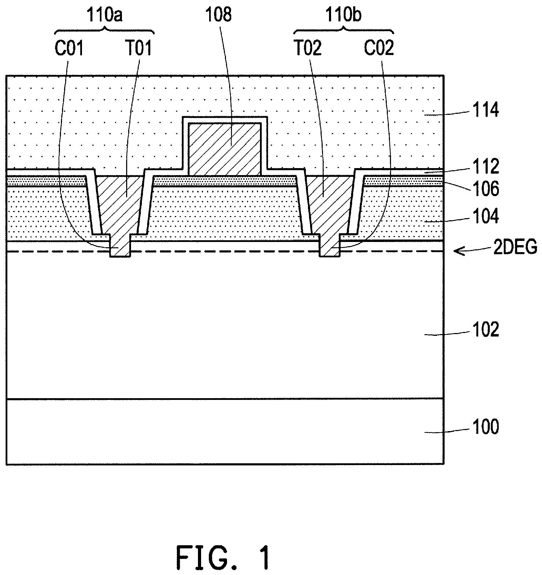

FIG. 1 is a schematic cross-sectional view of a GaN device according to a first embodiment of the disclosure. Referring to FIG. 1, a GaN device of the first embodiment includes a substrate 100, a channel layer 102 disposed on the substrate 100, a barrier layer 104 disposed on the channel layer 102, a cap layer 106 disposed on the barrier layer 104, a gate 108 disposed on the cap layer 106, a source 110a and a drain 110b disposed on both sides of the gate 108, and multiple ohmic sidewall dams 112. In one embodiment, the substrate 100 includes, for example, a silicon substrate or any other semiconductor substrate. The channel layer 102 may be formed on the substrate 100 by an epitaxial process. A material of the channel layer 102 includes, for example, gallium nitride. Between the substrate 100 and the channel layer 102, a film (not shown) such as a nucleation layer or a buffer layer may be formed for improving epitaxial quality. A material of the barrier layer 104 may include aluminum gallium nitride (AlGaN). Since the material of the channel layer 102 and the material of the barrier layer 104 have different band gaps, a heterojunction may be formed at an interface of the channel layer 102 and the barrier layer 104, a quantum well may be formed therein, and electrons may be confined in the quantum well. Accordingly, a two-dimensional electron gas 2DEG is generated in the channel layer 102 close to the barrier layer 104, thereby forming an ON current.

Referring still to FIG. 1, a material of the cap layer 106 includes, for example, gallium nitride or aluminum nitride. The gate 108 is typically a metal gate, and may include one or more metals. In the first embodiment, the gate 108 is rectangular in cross-section. However, the disclosure is not limited thereto. In another embodiment, the gate 108 may be mushroom-shaped in cross-section and is suitable for a high frequency device. The source 110a and the drain 110b are formed in the cap layer 106 and the barrier layer 104. The source 110a has a trench portion T01, and a contact C01 located below the trench portion T01 and protruding into the channel layer 102. Similarly, the drain 110b has a trench portion T02, and a contact C02 located below the trench portion T02 and protruding into the channel layer 102. Since the contact C01 of the source 110a and the contact C02 of the drain 110b may directly contact 2DEG, contact resistance (Rc) can be significantly reduced. Although the source 110a and the drain 110b shown in FIG. 1 have a single monolithic structure, the disclosure is not limited thereto. In another embodiment, each of the source 110a and the drain 110b has a multi-layered structure, and the multi-layered structure is composed of multiple bowl-shaped stacks (not shown) in cross-section. Examples of a material of the source 110a and the drain 110b include, but are not limited to, gold (Au), molybdenum (Mo), aluminum (Al), titanium (Ti), and a combination thereof.

In FIG. 1, an ohmic sidewall dam 112 is disposed on a sidewall of the trench portion T01 of the source 110a and the trench portion T02 of the drain 110b. A material of the ohmic sidewall dam 112 includes, for example, silicon nitride, silicon oxide, aluminum oxide, aluminum nitride, or a combination thereof. Since the ohmic sidewall dam 112 acts as a barrier between the source 110a and the cap layer 106 and between the drain 110b and the cap layer 106, a leakage path from the gate 108 to the source 110a and the drain 110b through the cap layer 106 is naturally blocked, thereby improving electrical properties of the device. Likewise, a leakage path between the source 110a and the drain 110b (through the cap layer 106) is also blocked. The GaN device may further include a passivation layer 114 covering the gate 108 and the cap layer 106. The ohmic sidewall dam 112 may be disposed between the gate 108 and the passivation layer 114. Because of the process, a thickness of the ohmic sidewall dam 112 between the gate 108 and the passivation layer 114 may be smaller than a thickness of the ohmic sidewall dam 112 disposed on the sidewall of the trench portion T01 of the source 110a and the trench portion T02 of the drain 110b. The process will be described in detail in the following.

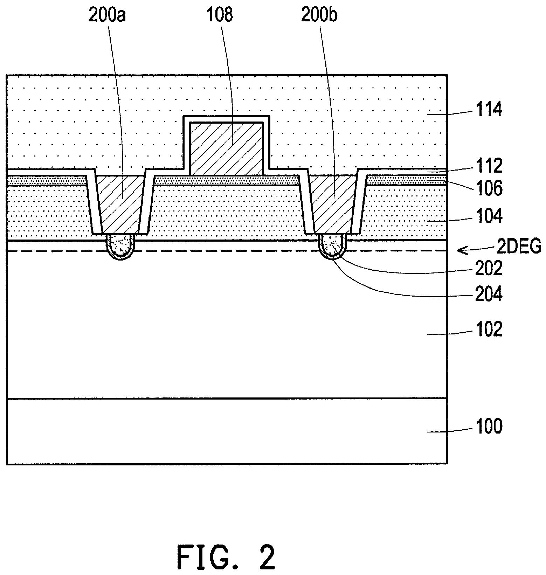

FIG. 2 is a schematic cross-sectional view of a GaN device according to a second embodiment of the disclosure. The same reference numerals as those in the first embodiment denote the same or similar members, and the same or similar members can be understood with reference to the description of the first embodiment and will not be described again.

Referring to FIG. 2, similarly to the first embodiment, a GaN device of the second embodiment includes the substrate 100, the channel layer 102 disposed on the substrate 100, the barrier layer 104 disposed on the channel layer 102, the cap layer 106 disposed on the barrier layer 104, the gate 108 disposed on the cap layer 106, and multiple ohmic sidewall dams 112. Differences lie in the structure of a source 200a and a drain 200b and multiple titanium nitride (TiN) protrusions 202 and a gold (Au)-containing layer 204 disposed below the source 200a and the drain 200b. In the present embodiment, the source 200a and the drain 200b are formed in the cap layer 106 and the barrier layer 104, the ohmic sidewall dam 112 is disposed on the a sidewall of the source 200a and the drain 200b, and thus, a leakage path from the gate 108 to the source 200a and the drain 200b through the cap layer 106 can be blocked. In the case where gold (Au) and titanium (Ti) are contained in a material of the source 200a and the drain 200b, since gold itself has good fluidity and titanium may be combined with nitrogen, the TiN protrusion 202 is formed below the source 200a and the drain 200b, and the Au-containing layer 204 is formed below the TiN protrusion 202. The TiN protrusion 202 may protrude into the channel layer 102 and may even directly contact 2DEG, thereby reducing the contact resistance (Rc). The Au-containing layer 204 may also cover the TiN protrusion 202. Since the Au-containing layer 204 is also a conductive material, the contact resistance is also reduced. In one embodiment, the material of the source 200a and the drain 200b further includes molybdenum (Mo), aluminum (Al), or a combination thereof.

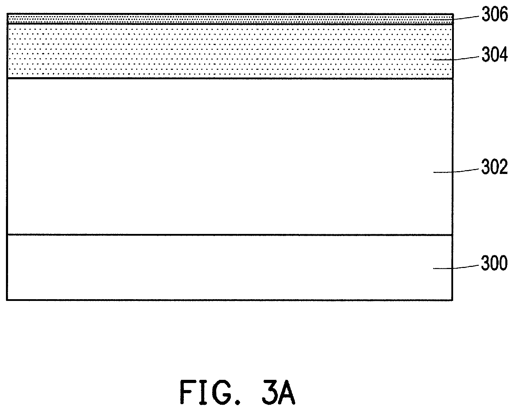

FIG. 3A to FIG. 3E are schematic cross-sectional views of a method for manufacturing a HEMT according to the second embodiment of the disclosure.

Referring to FIG. 3A, a channel layer 302 is formed on a substrate 300, a barrier layer 304 is formed on the channel layer 302, and a cap layer 306 is formed on the barrier layer 304. The substrate 300 includes, for example, a silicon substrate or any other semiconductor substrate. In the present embodiment, each of the above layers may be formed by an epitaxial process such as, for example, metal-organic chemical vapor deposition (MOCVD), pulsed laser deposition, molecular beam epitaxy (MBE), liquid phase epitaxy (LPE), vapor phase epitaxy (VPE), and selective epitaxial growth (SEG). A material of the channel layer 302 includes, for example, gallium nitride. A material of the barrier layer 304 includes, for example, aluminum gallium nitride. A material of the cap layer 306 includes, for example, gallium nitride or aluminum nitride. Before the channel layer 302 is formed, a nucleation layer (not shown) and a buffer layer (not shown) may be formed in advance on the substrate 300.

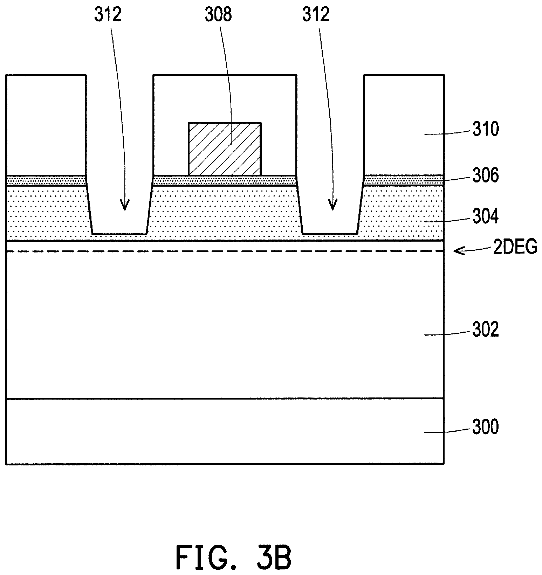

Next, referring to FIG. 3B, a gate 308 is formed on the cap layer 306, for example, in the following manner. First, a metal material is deposited on the cap layer 306. Then, an etching process is performed on the metal material. A two-dimensional electron gas 2DEG is generated in the channel layer 302 close to the barrier layer 304. Then, multiple trenches 312 are formed penetrating through the cap layer 306 and the barrier layer 304, for example, in the following manner. First, a patterned mask layer 310 is formed on the cap layer 306. Then, the exposed cap layer 306 and the barrier layer 304 therebelow are sequentially etched using the patterned mask layer 310 as an etching mask. The patterned mask layer 310 includes, for example, a photoresist layer, or is formed by stacking multiple material layers having different etching selection ratios. In one embodiment, an extension direction of the formed trench 312 is the same as an extension direction of the gate 308.

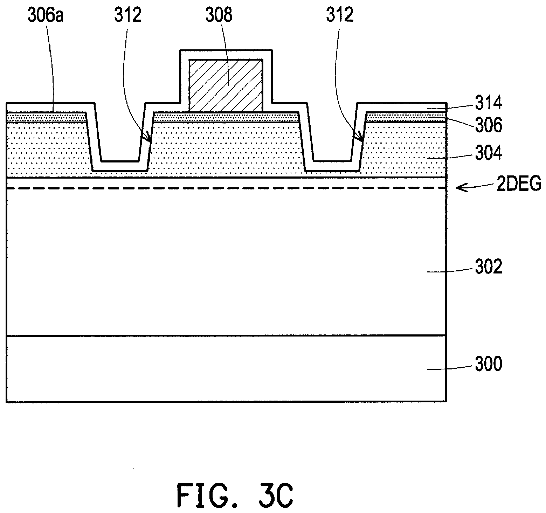

Then, referring to FIG. 3C, after the patterned mask layer 310 in FIG. 3B is removed, in order to form an ohmic sidewall dam, a dielectric material 314 may be conformally deposited on a sidewall and a bottom of each trench 312. A method for depositing the dielectric material 314 includes, for example, an atomic layer deposition (ALD) method. The dielectric material 314 includes, for example, silicon nitride, silicon oxide, aluminum oxide, aluminum nitride, or a combination thereof.

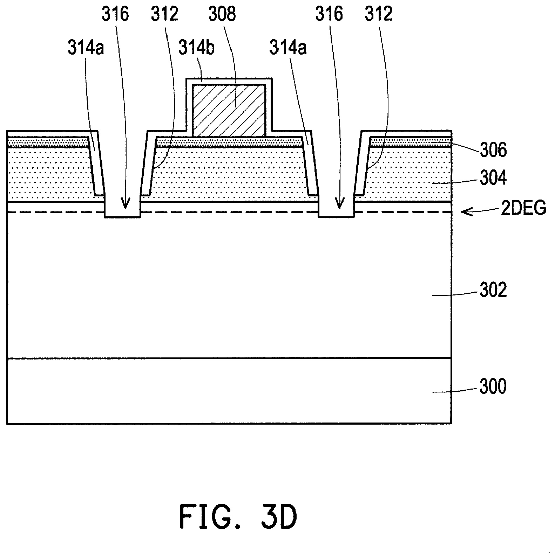

After that, referring to FIG. 3D, by removing a portion of the dielectric material (314) at the bottom of each trench 312, an ohmic sidewall dam 314a may be formed on the sidewall of the trench 312. In one embodiment, a method for removing the dielectric material at the bottom of the trench 312 includes, for example, anisotropic etching. Accordingly, it is easier to etch away the dielectric material on the same plane as the bottom of the trench 312 than the dielectric material on a different plane from the bottom of the trench 312. By controlling a process parameter, the dielectric material may also remain on a surface of the gate 308, thereby forming an entire layer of an ohmic sidewall dam 314b. Next, multiple openings 316 are formed below the trenches 312 into the channel layer 302 and contact 2DEG. In one embodiment, a method for forming the opening 316 is to sequentially etch the exposed barrier layer 304 and the channel layer 302 therebelow directly using the ohmic sidewall dams 314a and 314b as etching masks. However, the disclosure is not limited thereto.

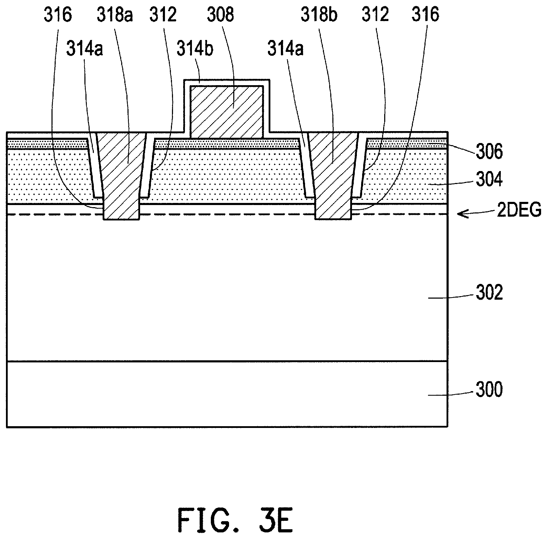

Then, referring to FIG. 3E, a source 318a and a drain 318b are formed in the trench 312 and the opening 316. The source 318a and the drain 318b are separated from the cap layer 306 by the ohmic sidewall dam 314a. Thus, leakage from the gate 308 to the source 318a and the drain 318b can be blocked, and a hump phenomenon in Id-Vg of the device can be suppressed.

In one embodiment, a method for forming the source 318a and the drain 318b includes, for example, a dual damascene process. The ohmic sidewall dam 314a in FIG. 3D may be formed, for example, in the following manner. First, another patterned mask layer (not shown) is formed on the overall structure to expose the dielectric material (314) above a portion where the opening 316 is to be formed. Then, the exposed dielectric material (314) and the barrier layer 304 and the channel layer 302 therebelow are sequentially etched using the above patterned mask layer as an etching mask. That is, the trench 312 has a strip shape, and the opening 316 therebelow is similar to a contact window opening and is provided below each trench 312. Thus, by depositing or filling a metal into the trench 312 and the opening 316, the source 318a and the drain 318b may be formed.

In another embodiment, the source 318a and the drain 318b are formed, for example, in the following manner. First, a metal material is deposited in the trench 312 and the opening 316. Then, the metal material is patterned. In still another embodiment, the source 318a and the drain 318b are formed, for example, in the following manner. First, a metal material is deposited to fill the trench 312 and the opening 316. Then, the metal material except that in the trench 312 and the opening 316 is lifted off.

## Claims

1. A gallium nitride device, comprising:
a substrate (100, 300);
a channel layer (102, 302), disposed on the substrate (100, 300);
a barrier layer (104, 304), disposed on the channel layer (102, 302);
a cap layer (106, 306), disposed on the barrier layer (104, 304);
a gate (108, 308), formed on the cap layer (106, 306);
a source (110a, 200a, 318a) and a drain (110b, 200b, 318b), formed in the cap layer (106, 306) and the barrier layer (104, 304), wherein each of the source (110a, 200a, 318a) and the drain (110b, 200b, 318b) has a trench portion (T01, T02), and a contact (C01, C02) below the trench portion (T01, T02) and protruding into the channel layer (102, 302); and
a plurality of ohmic sidewall dams (112, 314a, 314b), disposed on a sidewall of the trench portion (T01, T02) of each of the source (110a, 200a, 318a) and the drain (110b, 200b, 318b).

2. The gallium nitride device according to claim 1, wherein
a two-dimensional electron gas is generated in the channel layer (102, 302) close to the barrier layer (104, 304), and the contact (C01, C02) of each of the source (110a, 200a, 318a) and the drain (110b, 200b, 318b) is in direct contact with the two-dimensional electron gas.

3. The gallium nitride device according to claim 1, wherein
a material of the source (110a, 200a, 318a) and the drain (110b, 200b, 318b) comprises Au, Mo, Al, Ti, or a combination thereof.

4. A gallium nitride device, comprising:
a substrate (100, 300);
a channel layer (102, 302), disposed on the substrate (100, 300);
a barrier layer (104, 304), disposed on the channel layer (102, 302);
a cap layer (106, 306), disposed on the barrier layer (104, 304);
a gate (108, 308), formed on the cap layer (106, 306);
a source (110a, 200a, 318a) and a drain (110b, 200b, 318b), formed in the cap layer (106, 306) and the barrier layer (104, 304), wherein a material of the source (110a, 200a, 318a) and the drain (110b, 200b, 318b) comprises Au and Ti;
a plurality of ohmic sidewall dams (112, 314a, 314b), disposed on a sidewall of the source (110a, 200a, 318a) and the drain (110b, 200b, 318b);
a plurality of TiN protrusions (202), located below the source (110a, 200a, 318a) and the drain (110b, 200b, 318b) and protruding into the channel layer (102, 302); and
an Au-containing layer (204), located below the plurality of TiN protrusions (202).

5. The gallium nitride device according to claim 4, wherein
a two-dimensional electron gas is generated in the channel layer (102, 302) close to the barrier layer (104, 304), and the plurality of TiN protrusions (202) are in direct contact with the two-dimensional electron gas.

6. The gallium nitride device according to claim 4, wherein
the material of the source (110a, 200a, 318a) and the drain (110b, 200b, 318b) further comprises Mo, Al, or a combination thereof.

7. The gallium nitride device according to claim 1 or 4, further comprising:
a passivation layer (114), covering the gate (108, 308) and the cap layer (106, 306).

8. The gallium nitride device according to claim 7, wherein
the plurality of ohmic sidewall dams (112, 314a, 314b) are further disposed between the gate (108, 308) and the passivation layer (114).

9. The gallium nitride device according to claim 1 or 4, wherein
a material of the plurality of ohmic sidewall dams (112, 314a, 314b) comprises silicon nitride, silicon oxide, aluminum oxide, or a combination thereof.

10. The gallium nitride device according to claim 1 or 4, wherein
each of the source (110a, 200a, 318a) and the drain (110b, 200b, 318b) has a multi-layered structure composed of a plurality of bowl-shaped stacks.

11. A method for manufacturing a high electron mobility transistor, comprising:
forming a channel layer (102, 302) on a substrate (100, 300);
forming a barrier layer (104, 304) on the channel layer (102, 302);
forming a cap layer (106, 306) on the barrier layer (104, 304);
forming a gate (108, 308) on the cap layer (106, 306);
forming a plurality of trenches (312) penetrating through the cap layer (106, 306) and the barrier layer (104, 304);
forming a plurality of ohmic sidewall dams (112, 314a, 314b) on a sidewall of the plurality of trenches (312);
forming a plurality of openings (316) below the plurality of trenches (312) into the channel layer (102, 302); and
forming a source (110a, 200a, 318a) and a drain (110b, 200b, 318b) in the plurality of trenches (312) and the plurality of openings (316), wherein the source (110a, 200a, 318a) and the drain (110b, 200b, 318b) are separated from the cap layer (106, 306) by the plurality of ohmic sidewall dams (112, 314a, 314b).

12. The method for manufacturing a high electron mobility transistor according to claim 11, wherein
a method for forming the source (110a, 200a, 318a) and the drain (110b, 200b, 318b) comprises a dual damascene process.

13. The method for manufacturing a high electron mobility transistor according to claim 11, wherein forming the source (110a, 200a, 318a) and the drain (110b, 200b, 318b) comprises:
depositing a metal material in the plurality of trenches (312) and the plurality of openings (316); and
patterning the metal material.

14. The method for manufacturing a high electron mobility transistor according to claim 11, wherein forming the source (110a, 200a, 318a) and the drain (110b, 200b, 318b) comprises:
depositing a metal material to fill the plurality of trenches (312) and the plurality of openings (316); and
lifting off the metal material except that in the plurality of trenches (312) and the plurality of openings (316).

15. The method for manufacturing a high electron mobility transistor according to claim 11, wherein forming the plurality of ohmic sidewall dams (112, 314a, 314b) comprises:
conformally depositing a dielectric material (314) on the sidewall and a bottom of each of the plurality of trenches (312); and
removing a portion of the dielectric material (314) at the bottom of each of the plurality of trenches (312).
